# EUROPEAN PATENT SPECIFICATION

(11) **EP 2 425 694 B1**
(45) Date of publication and mention of the grant of the patent: **01.11.2017**
(21) Application number: 09776568.9
(22) Date of filing: 28.04.2009
(51) Int. Cl.: H05K 7/20

(54) **COMMUNICATIONS NETWORKS NODE**
KOMMUNIKATIONSNETZKNOTEN
NOEUD DE RÉSEAU DE COMMUNICATIONS

(43) Date of publication of application: 07.03.2012
(73) Proprietor: Telefonaktiebolaget LM Ericsson (publ), 164 83 Stockholm (SE)
(72) Inventor: TROJER, Elmar, S-187 37 Taby (SE)
(74) Representative: Ericsson
(86) International application number: PCT/EP2009/003083
(87) International publication number: WO 2010/124700

(56) References cited:
- GB-A- 2 284 659
- US-A1- 2004 007 348
- US-B1- 6 538 883
- US-B1- 7 242 580

## Description

### Technical Field

The present invention relates generally to communications network nodes.

### Background

The growing demand for higher speeds in access networks, higher competition between network operators in the broadband market, and price erosion on optical components have led to an increased interest in fibre-based access technologies. In particular, the distance between the optical fibre and the end-user has reduced. In network architectures such as Fibre to the Curb (FTTC), Fibre to the Cabinet (FTTCab) and Fibre to the Neighbourhood (FTTN) local network equipment connects optical fibres from a local regional exchange to metallic cable, which metallic cable extends to the end user premises. In such network architectures a housing apparatus enclosing network node equipment, which terminates the metallic and optic fibres, is typically located outdoors in the vicinity of the end user premises to be serviced. For instance, patent document US 2004/0007348 A1 discloses a weatherproof cabinet for accommodating telecommunications equipment with a cooling compartment.

### Summary

We have realised that it would be beneficial to improve the way in which network node equipment is powered.

According to a first aspect of the invention there is provided a communications network node defined in appended claim 1. An advantage of the invention is that energy is recovered from the coolant which has received heat from the equipment is fed back to power the equipment. The heat exchanger comprises a thermoelectric generator. The thermoelectric generator preferably comprises a plurality of thermocouple devices connected in serial and parallel arrangement.

The node is arranged to supply electricity from the thermoelectric generator to the equipment.

The heat exchanger may be located above a region arranged to receive the equipment.

The node may comprise a divider structure which substantially thermally isolates the inlet region from the outlet region.

The divider structure is preferably arranged to receive the equipment such that an inlet portion of the equipment is located in communication with the inlet region and an outlet portion of the equipment is located in communication with the outlet region.

The node is preferably arranged to guide fluid upwardly into the outlet region. The node most preferably comprises a guide surface to guide the fluid upwardly into the fluid outlet region.

A cold side of the heat exchanger is desirably in thermal communication with an external surface of the node.

The node may desirably be suitable for location in an outdoor environment. The node preferably comprises a street side cabinet.

The node preferably comprises a housing arranged to enclose the communications network node equipment, which equipment arranged to provide communication between communication network links. The housing preferably encloses the pathway and the heat exchanger.

The pathway may extend away from the housing, with the heat exchanger located remotely from the housing.

### Brief description of drawings

Various embodiments of the invention will now be described, by way of example only, with relevance to the following drawings in which:
**Figure 1** is a schematic cross-sectional view of a communications network node,
**Figure 2** is a schematic view of a communications network node housing apparatus and connections to the apparatus,
**Figure 3** shows a thermoelectric generator,
**Figure 4** shows a circuit diagram, and
**Figure 5** shows a communications network node housing and a fluid pathway.

### Detailed Description

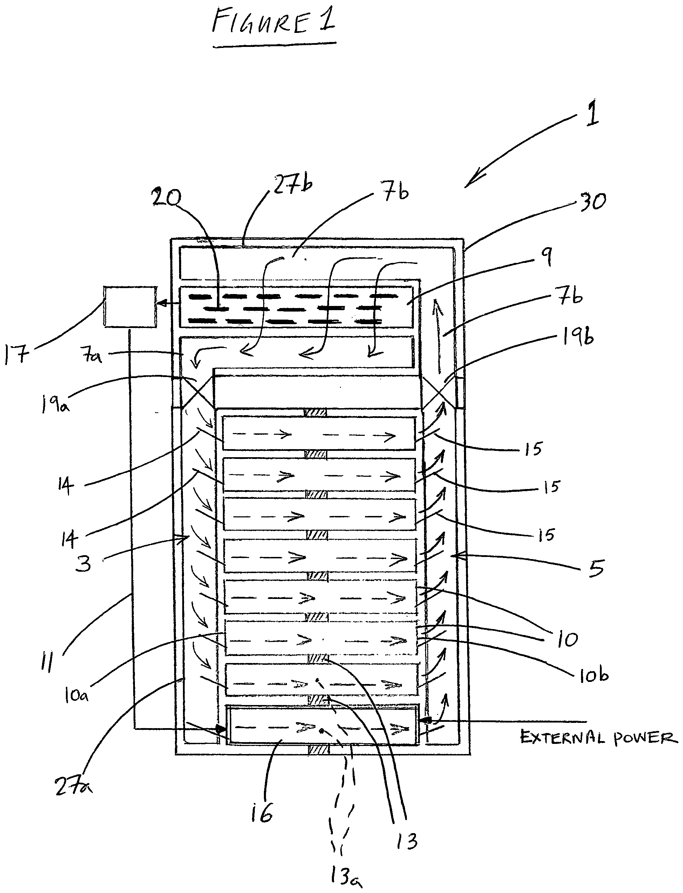

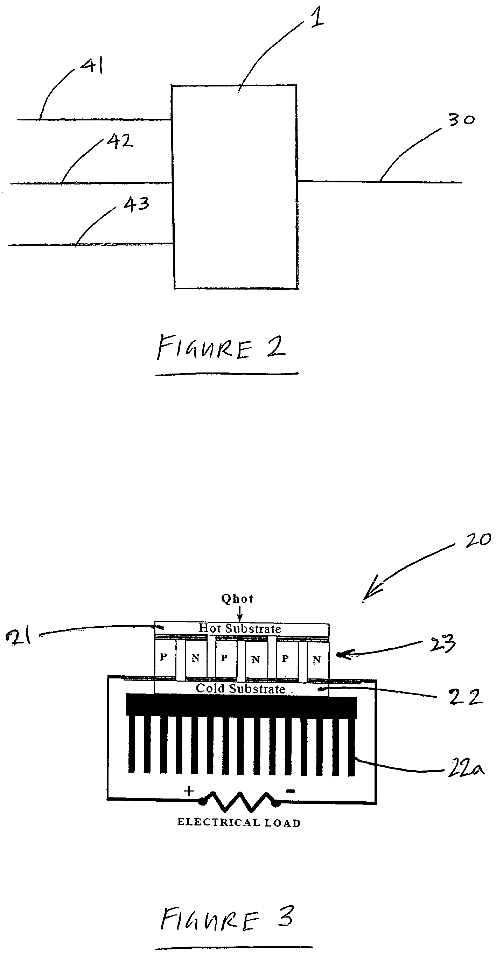

With reference to Figure 1 there is shown a communications network node comprising a housing apparatus 1 enclosing network node equipment 10 and heat exchange apparatus. The housing apparatus 1 is of the type generally known as a street side cabinet, a dog-house or a manhole and is suitable for location in an outdoor environment. With reference to Figure 2, the network node equipment 10 serves to provide a bridge between an optical fibre 30, which is connected to a regional or local exchange, and metallic cabling 41, 42 and 43, which are connected to respective user premises. The network node equipment 10 may comprise telecommunications network equipment such as a switch, Internet Protocol Digital Subscriber Line Access Multiplexer (IPDSLAM), or an Optical Network Unit (ONU), for example. As will be described below a thermoelectric generator arrangement converts heat produced by the equipment 10 to produce power which is fed back to an electrical power supply unit 16.

As is described in detail below, the node comprises an inlet region 3 for coolant air to flow towards the equipment 10 and an outlet region for coolant air to flow away from the equipment, and the apparatus further comprises a pathway comprising pathway portions 7a and 7b, defined by respective conduit structures 27a and 27b to connect the inlet region 3 to the outlet region 5. The node further comprises a heat exchange arrangement 9 which is in thermal communication with the pathway. Coolant air is circulated through the equipment and the pathway in order to ensure that the equipment does not overheat.

The equipment 10 comprises a plurality of equipment units which, as shown in Figure 1, are arranged in a rack assembly with the units arranged one above the other.

One end of 10a of each of the equipment units is arranged to receive air from the inlet region 3. Adjacent to the respective ends 10a there are provided guide surfaces 14 which save to deflect air towards said respective ends 10a.

On entering the equipment 10, the air receives heat produced by the equipment and the heat air is conveyed towards respective opposite ends 10b of the equipment units. The heated air exits the equipment units at the ends 10b and enters into the outlet region 5. Advantageously, guide surfaces 15 deflect the output heated air upwards, thereby assisting the conveyance of the air towards the pathway. The heated air rises from the outlet region towards an uppermost part of the pathway. Conveyance of the air towards the uppermost part of the pathway is assisted by a fan assembly 19b which urges the heated air upwards. On reaching the uppermost part of the pathway the air is drawn through the heat exchange arrangement 9.

The heat exchange arrangement 9 comprises a plurality of thermoelectric generators 20. One such generator is shown in Figure 3. The generator 20 comprises a hot side 21 and a cold side substrate 22. The hot side substrate and the cold side substrate 22 sandwich an array 23 of p-pellets and n-pellets to form a thermocouple device. The hot side substrate is in thermal communication with the environment external of the apparatus. As can be seen in Figure 3, the cold side substrate is connected to cooling fin structure 22a.

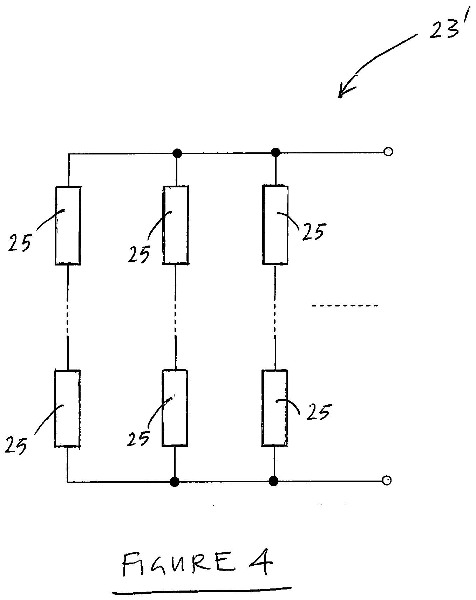

The temperature gradient between the hot side substrate 21 and the cold side substrate 22 produces electrical power derived from the movement of electrical carriers through thermoelectric pellets brought on by a heat flow. Heat is effectively exchanged for electrical power. By the Seebeck effect, positive charge in one of the p-pellets and electrons in an adjacent n-pellet move towards the heat sink producing a small voltage. Since the p-pellets and the n-pellets are connected in series the total voltage produced by the generator is in the sum of the voltages. The voltage is fed to a DC/DC converter 17, which in turn, is connected to the power supply unit 16 of the apparatus 1. Although serial connection of n-pellets and p-pellets is shown, pairs of the pellets may be arranged in parallel formation, or in a serial/parallel arrangement. Such a hybrid serial/parallel arrangement 23' is shown in Figure 4, with respective pairs of n-pellets and p-pellets shown schematically as circuit elements 25 and multiple elements 25 connected in series on each parallel branch. Advantageously, by connecting the pellets in this manner the need for the DC/DC converter is obviated.

The region 3 and the outlet region 5 are substantially thermally isolated from one another by virtue of a divider wall structure 13. This ensures that there is substantially no conduction of heat between air at the inlet region 3 and air at the outlet region 5. As can be seen from Figure 1, suitably dimensioned vertically-spaced apertures 13a are conveniently provided in the divider structure 13 to allow racking of the equipment units 10 and the power supply unit 16.

Outer casing 30 of the housing apparatus 1 is advantageously sealed such that ingress of air from the exterior environment is substantially prevented into the internal volume of the apparatus, or at least into the pathway. This results in the coolant air being circulated in a closed system and accordingly the accumulation of dust in the fans of the equipment units 10 and the power supply 16 is significantly reduced. Advantageously, this will result in reduced maintenance time required to service the housing apparatus 1 in respect of replacing or renewing fan components, such as dust filters, in view of dust accumulation which brings about energy inefficiencies in powering the fans. The same advantages of reduced maintenance apply in respect of the fans 19a and 19b.

Advantageously, by feeding back power to the power supply unit recovered from heat to output by the equipment units 10 and the power supply unit itself, the external power required to be supplied to the apparatus is reduced. This would otherwise have been energy which would simply have been dissipated into the exterior environment. A further important advantage is that by converting the produced heat to electrical energy, the quantity of heat inside the apparatus is reduced. This, in turn means that the energy required to achieve sufficient cooling is reduced.

Coolant air follows a substantially horizontal path through the equipment units 10 stemming from the fact that the housing apparatus 1 is fixed in a substantially upright position. However, in an alternative embodiment the housing apparatus 1 is arranged in a tilted condition such that the inlet ends 10a of the equipment units 10 are higher than the outlet ends 10b. The housing could be inclined at an angle of around 20° to 30° relative to the vertical. Alternatively, the housing 1 could remain upright whereas the rack assembly is arranged to hold the equipment units 10 at a suitable angular attitude. In both of those embodiments the angular inclination of the passage of air through the units acts to increase the flow of air therethrough which reduces the energy required for cooling.

In an alternative embodiment, additional cooling of the air could be achieved by using the electrical power derived from output heat to power a Peltier cooler device.

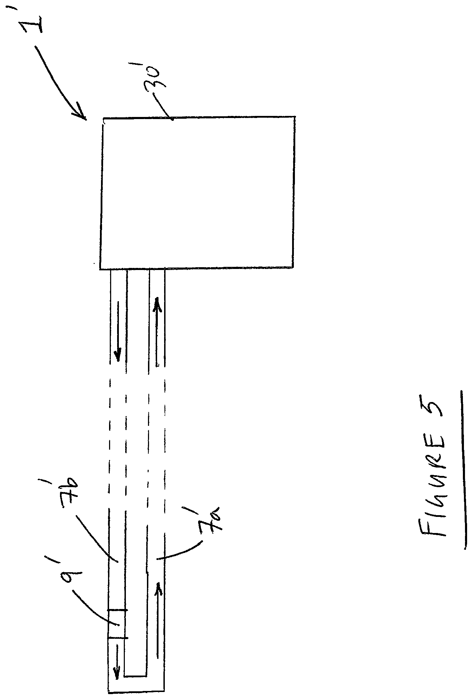

In a further alternative embodiment comprising a housing apparatus 1' shown in Figure 5, a pathway 7a', 7b' extends remotely from an exterior casing 30' of the apparatus which encloses telecommunication units to a heat exchange arrangement 9' which is also remotely located. The heat exchange arrangement 9' could be located at domestic or commercial premises and could be arranged to transfer heat from the coolant air to heat water (or another fluid) for example for use in providing heating to the premises.

In another embodiment, coolant conduits of multiple housing apparatus, which are in proximity to each other, are connected to a common or shared heat exchanger.

In further alternative embodiments, liquid, such as water, would be used as the coolant fluid.

## Claims

1. Communications network node comprising communications equipment (10); the node further comprising, an inlet region (3) for coolant to flow towards the equipment and an outlet region (5) for the coolant to flow away from the equipment, a pathway (7a, 7b) from the outlet region to the inlet region, the pathway forming part of a closed circuit for the coolant, a heat exchanger (9) in thermal communication with the pathway, and **characterised by** a thermoelectric generator (20) comprised in the heat exchanger (9), the thermoelectric generator being arranged to produce electricity from the heated coolant and supply electricity to the communications equipment.

2. Node as claimed in claim 1 in which the thermoelectric generator comprises a plurality of thermocouple devices (20) connected in serial and parallel arrangement.

3. Node as claimed in any preceding claim in which the heat exchanger (9) is located above a region arranged to receive the equipment (10).

4. Node as claimed in any preceding claim which comprises a divider structure (13) which substantially thermally isolates the inlet region (3) from the outlet region (5).

5. Node as claimed in claim 4, the divider structure (13) arranged to receive the equipment (10) such that an inlet portion (10a) of the equipment is located in communication with the inlet region (3) and an outlet portion of the equipment is located in communication with the outlet region (5).

6. Node as claimed in any preceding claim arranged to guide fluid upwardly into the outlet region (5).

7. Node as claimed in claim 6 which comprises a guide surface (15) to guide the fluid upwardly into the fluid outlet region (5).

8. Node as claimed in any preceding claim in which a cold side (22) of the heat exchanger (9) is in thermal communication with an external surface of the node.

9. Node as claimed in any preceding claim arranged to be suitable for location in an outdoor environment.

10. Node as claimed in any preceding claim which comprises a street side cabinet.

11. Node as claimed in any preceding claim which comprises a housing (1) arranged to enclose the communications equipment (10), which equipment is arranged to provide communication between communication network links (30, 41, 42, 43).

12. Node as claimed in claim 11 in which the housing (1) encloses the pathway (7a, 7b) and the heat exchanger (9).

13. Node as claimed in claim 12 in which the pathway extends away from the housing (1) and the heat exchanger (9) located remotely from the housing.

## Patentansprüche

1. Kommunikationsnetzknoten, umfassend einer Kommunikationseinrichtung (10); wobei der Knoten ferner einen Einlassbereich (3), damit Kühlmittel in Richtung der Einrichtung strömt, und einen Auslassbereich (5) umfasst, damit das Kühlmittel von der Einrichtung weg strömt, wobei eine Leitung (7a, 7b) von dem Auslassbereich zu dem Einlassbereich verläuft, wobei die Leitung einen Teil eines geschlossenen Kreislaufs für das Kühlmittel bildet, wobei ein Wärmetauscher (9) in thermischer Verbindung mit der Leitung ist, und **gekennzeichnet durch**
einen thermoelektrischen Generator (20), der in dem Wärmetauscher (9) enthalten ist, wobei der thermoelektrische Generator eingerichtet ist, um Elektrizität aus dem erwärmten Kühlmittel zu erzeugen und Strom zu der Kommunikationseinrichtung zuzuführen.

2. Knoten nach Anspruch 1, wobei der thermoelektrische Generator mehrere in axialer und paralleler Anordnung geschaltete Thermoelementeinrichtungen (20) aufweist.

3. Knoten nach einem vorhergehenden Anspruch, wobei sich der Wärmetauscher (9) oberhalb eines Bereichs befindet, der eingerichtet ist, um die Einrichtung (10) aufzunehmen.

4. Knoten nach einem vorhergehenden Anspruch, wobei er eine Trennstruktur (13) aufweist, die den Einlassbereich (3) im Wesentlichen thermisch von dem Auslassbereich (5) isoliert.

5. Knoten nach Anspruch 4, wobei die Teilerstruktur (13) eingerichtet ist, um eine Einrichtung (10) aufzunehmen, so dass ein Einlassabschnitt (10a) des Gerätes sich in Verbindung mit dem Einlassbereich (3) befindet, und sich ein Auslassabschnitt der Einrichtung sich in Verbindung mit dem Auslassbereich (5) befindet.

6. Knoten nach einem vorhergehenden Anspruch, der eingerichtet ist, um ein Fluid nach oben in den Auslassbereich (5) zu führen.

7. Knoten nach Anspruch 6, der eine Führungsfläche (15) umfasst, um das Fluid nach oben in den Fluidauslassbereich (5) zu führen.

8. Knoten nach einem vorhergehenden Anspruch, wobei eine kalte Seite (22) des Wärmetauschers (9) in thermischer Verbindung mit einer äußeren Oberfläche des Knotens steht.

9. Knoten nach einem vorhergehenden Anspruch, der so eingerichtet ist, dass er für eine Lage in einer Außenumgebung geeignet ist.

10. Knoten nach einem vorhergehenden Anspruch, der eine Straßenkabine aufweist.

11. Knoten nach einem vorhergehenden Anspruch, der ein Gehäuse (1) aufweist, das eingerichtet ist, um die Kommunikationseinrichtung (10) zu umschließen, wobei die Einrichtung eingerichtet ist, eine Kommunikation zwischen Kommunikationsnetzverbindungen (30, 41, 42, 43) bereitzustellen.

12. Knoten nach Anspruch 11, wobei das Gehäuse (1) die Leitung (7a, 7b) und den Wärmetauscher (9) umschließt.

13. Knoten nach Anspruch 12, wobei sich die Leitung von dem Gehäuse (1) weg erstreckt, und wobei sich der Wärmetauscher (9) entfernt von dem Gehäuse befindet.

## Revendications

1. Noeud de réseau de communication comprenant un équipement de communication (10) ; le noeud comprenant en outre, une région d'entrée (3) pour qu'un liquide de refroidissement s'écoule vers l'équipement et une région de sortie (5) pour que le liquide de refroidissement s'écoule loin de l'équipement, un chemin (7a, 7b) allant de la région de sortie à la région d'entrée, le chemin formant une partie d'un circuit fermé pour le liquide de refroidissement, un échangeur de chaleur (9) en communication thermique avec le chemin,
et **caractérisé par**
un générateur thermoélectrique (20) compris dans l'échangeur de chaleur (9), le générateur thermoélectrique étant agencé pour produire de l'électricité à partir du liquide de refroidissement chauffé et pour fournir l'électricité à l'équipement de communication.

2. Noeud selon la revendication 1, dans laquelle le générateur thermoélectrique comprend une pluralité de dispositifs à thermocouple (20) reliés dans un agencement série et parallèle.

3. Noeud selon l'une quelconque des revendications précédentes, dans lequel l'échangeur de chaleur (9) est situé au-dessus d'une région agencée pour recevoir l'équipement (10).

4. Noeud selon l'une quelconque des revendications précédentes, qui comprend une structure de séparateur (13) qui isole sensiblement de façon thermique la région d'entrée (3) de la région de sortie (5).

5. Noeud selon la revendication 4, la structure de séparateur (13) étant agencée pour recevoir l'équipement (10) de sorte qu'une portion d'entrée (10a) de l'équipement est située en communication avec la région d'entrée (3) et une portion de sortie de l'équipement est située en communication avec la région de sortie (5).

6. Noeud selon l'une quelconque des revendications précédentes, agencé pour guider du fluide vers le haut dans la région de sortie (5).

7. Noeud selon la revendication 6, qui comprend une surface de guidage (15) pour guider le fluide vers le haut dans la région de sortie de fluide (5).

8. Noeud selon l'une quelconque des revendications précédentes, dans lequel un côté froid (22) de l'échangeur de chaleur (9) est en communication thermique avec une surface externe du noeud.

9. Noeud selon l'une quelconque des revendications précédentes, agencé pour être approprié pour une localisation dans un environnement extérieur.

10. Noeud selon l'une quelconque des revendications précédentes, qui comprend un coffret côté rue.

11. Noeud selon l'une quelconque des revendications précédentes, qui comprend un logement (1) agencé pour englober l'équipement de communication (10), lequel équipement est agencé pour fournir une communication entre des liaisons de réseau de communication (30, 41, 42, 43).

12. Noeud selon la revendication 11, dans lequel le logement (1) englobe le chemin (7a, 7b) et l'échangeur de chaleur (9).

13. Noeud selon la revendication 12, dans lequel le chemin s'étend loin du logement (1) et de l'échangeur de chaleur (9) situé à distance du logement.
